# EUROPÄISCHE PATENTANMELDUNG

(11) **EP 0 757 414 A2**
(43) Veröffentlichungstag der Anmeldung: **05.02.1997**
(21) Anmeldenummer: 96110560.8
(22) Anmeldetag: 29.06.1996
(51) Int. Cl.: H01R 31/06

(54) **Adapter mit einem eine Kontaktierungsvorrichtung aufweisenden Träger**

(30) Priorität: 31.07.1995 DE 19528012
(71) Anmelder: KONTRON ELEKTRONIK GMBH, D-85386 Eching (DE)
(72) Erfinder: Horak, Dieter, 85368 Moosburg (DE)
(74) Vertreter: Bullwein, Fritz

(57) **Zusammenfassung**

Bei einem Adapter mit einem eine Kontaktierungsvorrichtung aufweisenden Träger zur elektrischen Verbindung von elektrischen Kontakten eines auf einer Platine aufgebrachten elektronischen Bauteils mit einem Testgerät weist der Träger zu seiner Befestigung an dem elektronischen Bauteil oder an der Platine mindestens einen Durchbruch für eine lösbare mechanische Verbindung auf.

Vorzugsweise wird die Kontaktierungsvorrichtung durch ein kontakteübergreifendes elektrisches Verbindungsstück mit rasterförmigen Leitungsabschnitten gebildet.

## Beschreibung

Die Erfindung bezieht sich auf einen Adapter mit einem eine Kontaktierungsvorrichtung aufweisenden Träger nach dem Oberbegriff des Patentanspruchs 1.

Derartige Adapter sind beispielsweise bekannt, um Testgeräte, wie Logic Analyzer oder In-circuit Emulatoren an Mikroprozessoren oder anderen integrierten Schaltungen, die in flachen Gehäusen eingegossen sind (FPGA Gehäuse), anzuschließen. Die hierzu üblichen "clip over" Adapter bestehen aus einer Adapterplatine als Träger, die eine Kontaktierungsvorrichtung in Form eines oder mehrerer Sockel mit elektrisch leitenden Federkontakten aufweisen. Dieser Adapter wird beispielsweise von oben auf ein SMD-gelötetes elektronisches Baute gesteckt. Die an dem Adapter angebrachten Federkontakte schaffen zum einen eine elektrische Verbindung zwischen den Kontakten (z. B. Pins, Anschlußbeine) des auf einer Platine aufgebrachten elektronischen Bauteils und einem Testgerät und zum anderen eine lösbare mechanische Verbindung zur Befestigung des Adapters an dem elektronischen Bauteil.

Mit zunehmender Miniaturisierung der elektronischen Bauteile werden die Kontakt- bzw. Pinabstände an den elektronischen Bauteilen, z. B. mit FPGA Gehäusen, immer geringer. Darüber hinaus nimmt auch die Größe bzw. die Stabilität der Kontakte bzw. Pins derart ab, daß eine mechanische Verbindung mittels Federkontakten an ihre mechanischen Grenzen stößt. Die Folge ist eine nicht ausreichende Befestigung des Adapters an dem elektronischen Bauteil und/oder ein unsicherer Kontakt mit Kurzschlußgefahr.

Es ist Aufgabe der Erfindung, einen Adapter eingangs genannter Art derart zu verbessern, daß er auch an elektronischen Bauteilen mit geringen Kontaktabmessungen und Kontaktabständen sicher befestigt werden kann. Durch die Befestigung soll sowohl ausreichender Halt bei mechanischer Belastung durch Testmaßnahmen als auch ein sicherer Kontakt zwischen der Kontaktierungsvorrichtung des Adapters und den Kontakten des elektronischen Bauteils gewährleistet sein.

Diese Aufgabe wird durch die kennzeichnenden Merkmale des Patentanspruchs 1 gelöst.
Erfindungsgemäß weist der Träger zu seiner Befestigung an dem elektronischen Bauteil oder an der Platine, auf der das elektronische Bauteil aufgebracht ist, mindestens einen Durchbruch für eine lösbare mechanische Verbindung auf.

Da die Kontaktierungsvorrichtung des Adapters üblicherweise am Rand des Trägers angebracht ist, kann beispielsweise ein Durchbruch in der Mitte des Trägers, d. h. auch oberhalb des Gehäuses des elektronischen Bauteils, vorgesehen sein. Reicht jedoch der Rand des Trägers über die Kontaktierungsvorrichtung hinaus, können auch ein oder mehrere Durchbrüche am Rand des Trägers vorgesehen sein, um den Träger mittels dieser Durchbrüche auf der das elektronische Bauteil aufweisenden Platine zu befestigen. Zur Befestigung wird eine lösbare mechanische Verbindung in dem Durchbruch vorgesehen. Diese Verbindung kann beispielsweise mittels einer Schraube, eines Schiebeverschlusses, eines Saugknopfes, einer wiederentfernbaren Verklebung oder eines Kunststoffschnappverschlusses hergestellt werden.

Durch diese Erfindung kann eine sichere Befestigung des Adapters an einem elektronischen Bauteil vorgenommen werden, da die Haltekraft der Befestigung nicht mehr durch die einzelnen Kontakte des Adapters aufgebracht werden muß.

Eine vorteilhafte Ausgestaltung der Erfindung ist der Gegenstand des Patentanspruchs 2.
Erfindungsgemäß wird die Kontaktierungsvorrichtung des Adapters durch ein kontakteübergreifendes elektrisches Verbindungsstück mit rasterförmigen Leitungsabschnitten gebildet.

Da erfindungsgemäß keine Haltekraft mehr zwischen den Kontakten des elektronischen Bauteils und der Kontaktierungsvorrichtung wirken muß, reicht es aus, einfache,an dem Träger angebrachte, in Richtung der Kontakte des elektronischen Bauteils leitende Verbindungsstücke ohne spezieller Befestigungsvorrichtung mit den Kontakten des elektronischen Bauteils in Berührung zu bringen.

Derartige Verbindungsstücke bestehen beispielsweise aus parallel angeordnete Kontaktabschnitte aufweisendem Isoliermaterial. Beispielsweise können hierfür Kunststoffe verwendet werden, in die bzw. um die eine Vielzahl von parallel angeordneten dünnen Metalldrähten eingegossen bzw. angebracht sind. Auch können Kunststoffe verwendet werden,die in abwechselnd leitenden und isolierenden Schichten aufgebaut sind. Hochauflösende Raster in Form von parallel angeordeten leitenden Abschnitten werden erfindungsgemäß bevorzugt.

Das Verbindungsstück wird derart angeordnet, daß sich zwischen den Kontakten des elektronischen Bauteils und den entsprechenden auf dem Träger aufgebrachten Kontaktanschlüssen für die Kontaktierungsvorrichtung elektrisch leitfähige Verbindungen ergeben. Unter dem Begriff kontakteübergreifend wird verstanden, daß sich das Verbindungsstück über mehrere oder alle nebeneinanderliegende elektrische Kontakte erstreckt, wodurch auch die Positionierung der Kontaktierung des Adapters mit dem elektronischen Bauteil erleichtert wird. Gleichzeitig wirkt das Verbindungsstück zwischen den nebeneinanderliegenden Kontakten des elektronischen Bauteils bzw. zwischen den Kontaktanschlüssen der Kontaktierungsvorrichtung als Isolator.

Ein derartiges Verbindungsstück kann beispielsweise auch Vorrichtungen zur Befestigung des Adapters am elektronischen Bauteil aufweisen. Somit ist eine einfache kurzschlußsichere Kontaktierung eines Adapters mit einem elektronischen Bauteil gewährleistet.

Diese Weiterbildung schafft durch die von den Kontakten des elektronischen Bauteils unabhängige Befestigung des Adapters an dem elektronischen Bauteil eine besonders einfache und kurzschlußsichere Verbindung zwischen der Kontaktierungsvorrichtung des Adapters und den Kontakten des elektronischen Bauteils.

In der Zeichnung ist ein Ausführungsbeispiel der Erfindung dargestellt. Es zeigt:
- Fig. 1: eine erste Möglichkeit, einen Durchbruch im Träger des Adapters vorzusehen,
- Fig. 2: eine zweite Möglichkeit, Durchbrüche an dem Träger des Adapters vorzusehen,
- Fig. 3: eine mögliche lösbare mechanische Verbindung eines elektronischen Bauteils mit einem Adapter, dessen Kontaktierungsvorrichtung Federkontakte aufweist und
- Fig. 4: zwei mögliche lösbare mechanische Verbindungen zwischen einem elektronischen Bauteil und einem Adapter, dessen Kontaktierungsvorrichtung ein kontakteübergreifendes elektrisches Verbindungsstück mit rasterförmigen Leitungsabschnitten in Form von in einer Richtung (vertikal) leitenden Kunststoffstreifen aufweist.

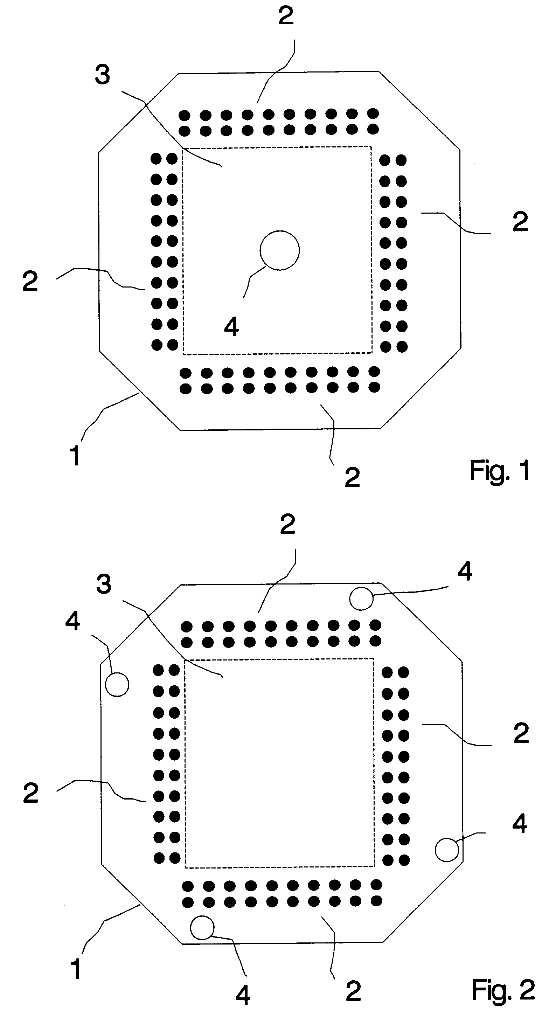

Fig. 1 zeigt einen Adapter mit einem eine Kontaktierungsvorrichtung 2 aufweisenden Träger 1, der beispielsweise für einen Mikroprozessor als elektronisches Baute 3 vorgesehen ist. In Fig. 1 ist der Durchbruch 4 des Trägers 1 in der Mitte des Trägers 1, der Kontaktierungsvorrichtung 2 und des elektronischen Bauteils 3, wenn der Träger 1 bereits auf das elektronische Bauteil 3 aufgesetzt wurde. Fig. 2 zeigt einen Adapter, der im Unterschied zu Fig. 1 vier Durchbrüche 4 am Rand des Trägers 1 aufweist. Da der Rand des Trägers 1 über das elektronische Bauteil 3 und dessen Kontakte entsprechend der Kontaktierungsvorrichtung 2 hinausreicht, kann nach dem Beispiel in Fig. 2 eine Befestigung des Trägers 1 über die Durchbrüche 4 an der Platine vorgenommen werden, auf der das Bauteil 3 aufgebracht ist.

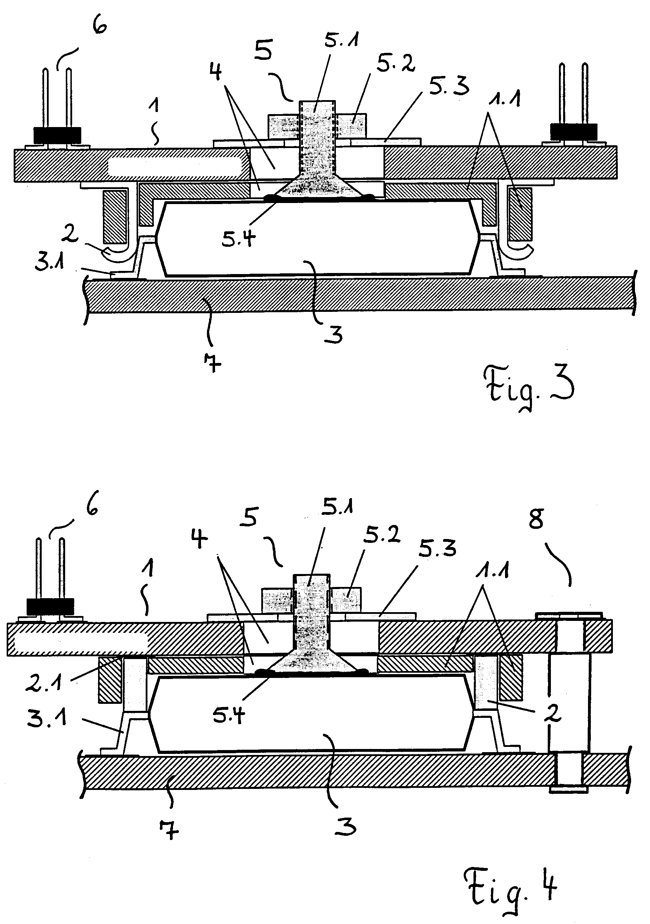

Fig. 3 zeigt einen Schnitt durch den Adapter, bestehend aus dem Träger 1 und der Kontaktierungsvorrichtung 2, durch das elektronische Bauteil 3, auf dem der Adapter aufgesetzt ist und durch die Platine 7, auf der das Bauteil 3 aufgebracht ist, in Seitenansicht.

Der Träger 1 weist einen Sockel 1.1 auf, durch den die Kontaktierungsvorrichtung 2 in Form von Federkontakten gehalten und mit dem Träger 1 verbunden wird. Die Federkontakte 2 bzw. die Kontaktierungsvorrichtung 2 ist elektrisch mit den Steckern 6 verbunden, die zu einem hier nicht dargestellten Testgerät weiterführen.

Im Träger 1 sowie im Sockel 1.1 des Trägers 1 ist jeweils ein Durchbruch 4 vorgesehen, durch den eine lösbare mechanische Verbindung 5 in Form einer Verschraubung führt. Die lösbare mechanische Verbindung 5 setzt sich aus einer Schraube 5.1, die mittels eines lösbaren Klebstoffes 5.4 auf der Oberseite des Gehäuses des Bauteils 3 aufgebracht ist, aus einer Beilagscheibe 5.3 und aus einer Mutter 5.2 zusammen.

In Fig. 4 sind gleiche Teile mit gleichen Bezugszeichen versehen. Im Unterschied zu Fig. 3 ist in Fig. 4 eine zusätzliche lösbare mechanische Verbindung 8 zwischen dem Träger 1 des Adapters und der Platine 7, auf der das Bauteil 3 aufgebracht ist, vorgesehen. Darüber hinaus ist die Kontaktierungsvorrichtung 2 im Unterschied zu Fig. 3 in Fig. 4 durch kontakteübergreifende elektrische Verbindungsstücke 2 mit rasterförmigen Leitungsabschnitten, hier in vertikaler Richtung leitende Kunststoffstreifen 2, gebildet, die über Kontaktflächen 2.1, deren Anordnung der Anordnung der Kontakte 3.1 des Bauteils 3 entspricht, mit dem Träger 1 leitend verbunden sind. Vorzugsweise erstreckt sich je ein in vertikaler Richtung leitender Kunststoffstreifen 2 horizontal (hier nicht dargestellt) jeweils über die gesamte Länge einer Kontaktreihe der Kontakte 3.1 auf einer Seite des Bauteils 3.

Die Kontaktstreifen 2 werden lediglich auf die Kontakte 3.1 des Bauteils 3 aufgesetzt. Kontaktzonen des in vertikaler Richtung leitenden Kunststoffstreifens 2, die jeweils zwischen einer Kontaktfäche 2.1 und einem Kontakt 3.1 liegen, bilden die elektrisch leitfähige Verbindung. In horizontaler Richtung, d. h. zwischen den einzelnen Kontakten 3.1 oder zwischen den einzelnen Kontaktflächen 2.1, wirkt der in nur vertikaler Richtung leitende, Kunststoffstreifen 2 als Isolator. Diese Art der elektrischen Verbindung ist besonders günstig, um Kurzschlüsse zu verhindern.

Eine wichtige Anforderung an das Verbindungsstück 2 für dessen erfindungsgemäße Anwendung ist, daß die Auflösung der abwechselnd geschichteten isolierenden Bereiche und leitenden Bereiche des Kunststoffes in Richtung der voneinander zu isolierenden Kontakte 3.1 oder Kontaktanschlüsse 2.1 mindestens doppelt so hoch wie die Abstände dieser nebeneinanderliegenden Kontakte 3.1 oder Kontaktanschlüsse 2.1 ist.

Die mechanische Befestigung des Adapters bzw. des Trägers 1 wird alternativ oder zusätzlich zur mechanischen Verbindung 5 des Trägers 1 mit dem Baute 3 durch die mechanische Verbindung 8 des Trägers 1 mit der Platine 7 vorgenommen. Die Verbindung 8 kann beispielsweise ebenfalls mittels einer Verschraubung durch Durchbrüche in dem Träger 1 und der Platine 7 hindurch und mittels eines Abstandsbolzens zwischen dem Träger 1 und der Platine 7 vorgenommen werden.

Anstelle einer Verschraubung kann die Verbindung 8 beispielsweise auch durch einen Kunststoffstift mit Schnappverbindung gebildet werden. Auch kann beispielsweise die Verbindung 5 statt mit einer Schraube mit einem auf dem Bauteil 3 haltenden Saugknopf vorgenommen werden.

## Patentansprüche

1. Adapter mit einem eine Kontaktierungsvorrichtung aufweisenden Träger zur elektrischen Verbindung von elektrischen Kontakten eines auf einer Platine aufgebrachten elektronischen Bauteils mit einem Testgerät, dadurch gekennzeichnet, daß der Träger (1, 1.1) zu seiner Befestigung an dem elektronischen Bauteil (3) oder an der Platine (7) mindestens einen Durchbruch (4) für eine lösbare mechanische Verbindung (5; 5.1, 5.2, 5.3, 5.4; 8) aufweist.

2. Adapter nach Patentanspruch 1, dadurch gekennzeichnet, daß die Kontaktierungsvorrichtung (2, 2.1) durch ein kontakteübergreifendes elektrisches Verbindungsstück mit rasterförmigen Leitungsabschnitten gebildet wird.
